# EUROPEAN PATENT SPECIFICATION

(11) **EP 0 591 604 B1**
(45) Date of publication and mention of the grant of the patent: **02.07.1997**
(21) Application number: 93103541.4
(22) Date of filing: 05.03.1993
(51) Int. Cl.: H05K 3/46, H05K 1/09

(54) **Via fill compositions**
Zusammensetzungen zum Füllen von Durchgangslöchern
Compositions pour le remplissage des trous d'interconnexion

(30) Priority: 05.10.1992 US 956273
(43) Date of publication of application: 13.04.1994
(73) Proprietor: E.I. DU PONT DE NEMOURS AND COMPANY, Wilmington Delaware 19898 (US)
(72) Inventor: Hormadaly, Jacob, Wilmington, Delaware 19803 (US); Mones, Arthur Harvey, Cary, North Carolina 27511 (US)
(74) Representative: von Kreisler, Alek, Dipl.-Chem.

(56) References cited:
- EP-A- 0 135 174
- EP-A- 0 449 309
- FR-A- 2 280 957
- US-A- 4 847 003

## Description

### FIELD OF INVENTION:

The invention is directed to thick film compositions and in particular to thick film paste compositions which are useful for forming interconnecting vias in multilayer electronic components.

### BACKGROUND OF THE INVENTION:

Increased circuit densities have stimulated the development of multilayer ceramic circuits. To address the need, two types of technologies were developed: (1) buried wiring and (2) screen printed multilayer interconnections on a single ceramic substrate.

Buried wiring ceramic interconnections consist of three major building blocks: dielectric layers such as alumina and alumina in combination with glass cordierite; metallizations such as Mo and W for processing at high temperatures in a reducing atmosphere, or precious metals and their alloys for processing at lower temperatures in air or inert atmospheres; and via fill conductors such as precious metals and their mixtures and alloys to connect the conductive tracks in adjacent and neighboring layers.

Dielectric layers are most frequently formed from green tapes which are films of finely divided particles of unsintered dielectric and inorganic binder materials dispersed in a mad of solid organic polymer which is readily volatilized upon firing the dielectric material. Such layers can, however, also be formed by applying dielectric thick film pastes to a substrate. Such thick film pastes are dispersions of finely divided dielectric solids and inorganic binder dispersed in an organic medium containing a polymeric binder dissolved in solvent.

Multilayer circuits are fabricated by providing holes (vias) in the dielectric tape layers, screen printing metal tracks on the tape layer and filling the vias with conductor paste; several layers of patterned green tape sheets having filled vias are then stacked together, laminated and fired at an appropriate temperature to effect volatilization of the organic materials contained in the conductive and dielectric layers, sintering of the conductive metals and densification of the dielectric material. Depending on the materials utilized in any particular system, they can be fired at low temperatures (800-1000C) or high temperatures (1300-1600C) to form buried wiring ceramic interconnections.

Screen printed multilayer interconnections are formed by screen printing pastes of dielectrics, conductors and feed-through conductors (the equivalent of via fill in buried wiring) on a ceramic substrate to build successive layers. Usually each layer and sometimes each component (dielectrics and conductors) of the layer is printed, dried and fired separately. This process is then repeated to generate a multilayer structure. This technique is limited to several layers while buried wiring (tape) structures with over 60 layers have been reported.

It is useful, for example, to fabricate circuits with buried silver conductors and have gold metallization on the top layer for wire bonding, reliability and reduced costs. Such a structure having buried Ag and top Au conductors requires the electrical connection of the buried Ag with the outer Au by means of thick film via fill paste composition.

Connection of Ag with Au using Ag, Au or Ag/Pd via fill pastes, suffers from several shortcomings. For example, Ag diffuses easily into Au, thus discoloring the Au conductor and decreasing the reliability by increasing the risk for Ag migration on the top layer. Diffusion of Ag and Au each into the other, especially at the temperature range (700-950C) used to sinter them, leads to voids and ultimately to open circuits. Similar problems are encountered in the connection of buried Ag with top Cu conductors with via fill pastes of Ag, Cu, Au and Ag/Pd. Connection of Ag with Cu by Ag, Cu and Ag/Pd via fill pastes may lead to a formation of Ag-Cu eutectic which has a lower melting temperature than Cu and Ag, which becomes subject to melting and thus may lead to an open circuit.

Therefore, there is a significant need for a via fill composition which can connect dissimilar metals (Ag and Au or Ag and Cu, for example) and provide a barrier to the diffusion of one metal into the other. In addition to its barrier properties, this composition should also have low resistance and be compatible with the mechanical requirements of multilayer structure.

### SUMMARY OF THE INVENTION:

In its primary aspect, the invention is directed to a thick film paste composition comprising finely divided particles of a conductive metal which is not alloyable with silver selected from the group consisting of Os, Ru, Ir, Rh and mixtures and alloys thereof dispersed in a liquid organic medium.

In a further aspect, the invention is directed to a fired multilayer electronic structure comprising alternating layers of fired dielectric and conductor patterns having interconnecting vias filled with the above-referred composition in which (1) the fired dielectric tape layer is comprised of sintered alumina or finely divided particles of sintered alumina dispersed in a matrix of inorganic binder and (2) the conductor patterns and via fill composition have been fired in air to effect complete volatilization of the organic medium therefrom and sintering of the conductive metal(s).

In a still further aspect, the invention is directed to a fired multilayer structure comprising alternating layers of fired dielectric material and conductor patterns having interconnecting vias filled with the above-referred composition in which (1) the fired dielectric tape layer is comprised of sintered alumina or finely divided particles of sintered alumina dispersed in a matrix of inorganic binder and (2) the conductor patterns have the same composition as the via fill composition and both the conductor patterns and via fill compositions have been fired in air to effect complete volatilization of the organic medium therefrom and sintering of the conductive metal.

### DETAILED DESCRIPTION OF THE INVENTION:

The via fill compositions of the invention will ordinarily be applied by screen printing. Thus, they will be in the form of screen printable thick film pastes. These via fill pastes do not require the use of an inorganic binder and therefore are comprised of finely divided particles of metal which is not alloyable with Ag. i.e., which does not form solid solutions with Ag, dispersed in a liquid organic medium. Suitable metals for this purpose are Os, Ru, Ir, Rh and mixtures and alloys thereof. Of these metals, Ru is preferred. The metal particles may be partially oxidized and it is preferred that they have a surface area of 0.1-5 m²/g. The precise proportions of the metal and the liquid organic medium will depend upon the rheology of the paste. Ordinarily, however, the pastes will contain 90-99% by weight metal particles dispersed in 1-10% liquid organic medium. So long as the rheology of the paste is appropriate for the printing apparatus used, the proportions of the medium and metal are not critical. When the compositions are fired, the organic medium is completely volatilized from the paste and the conductive metal particles are sintered.

In making hybrid multilayer components, the conductive layer patterns are formed by screen printing thick film conductor pastes. Such pastes are comprised of finely divided particles of silver or low alloys of silver dispersed in a liquid organic medium. The paste in some instances may also contain a small amount of inorganic binder, which usually will not exceed about 10% by weight of the solids content of the conductive paste. At least about 0.5% by weight inorganic binder, if used at all, will be necessary to obtain adequate technical effect. The softening point of the inorganic binder will be lower than the sintering temperature of silver. Upon firing multilayer assemblages having thick film paste conductive layers, the organic medium is completely volatilized from the paste and the silver metal particles are sintered. If indeed an inorganic binder is used at all, it will be sintered also. It should be noted that the above-described via fill compositions are equally suitable for use in forming conductive layers in accordance with the invention.

With respect to the via fill composition, the conductive layer pastes as well as the green tape, the particle size of the solids in each is not by itself critical so long as the particles are not so large as to affect sintering adversely or to be too large for screen printing or so small as to cause handling difficulties. Therefore, the particle size of the solids for use in the invention should be within the range of 0.1-20 microns and preferably In the range of 0.5-10 microns. The dielectric layers for use in multilayers can be applied either in the form of thick film pastes or in the form of green (unfired) tape.

In the case of dielectric thick film pastes, the dielectric separating layers are screen printed. In the case of dielectric green tapes, one or more layers of the tapes are laminated onto the underlying substrate. Dielectric thick pastes are comprised of finely divided particles of dielectric solids dispersed in a liquid organic medium while dielectric green tapes are comprised of finely divided particles of dielectric solids dispersed in a solid matrix of organic polymer. In both instances, when the layers are fired, the dispersion medium becomes completely volatilized and the dielectric solids are densified.

When green tape is used to make the dielectric layers, whether or not the tape contains an inorganic binder depends upon the temperature at which the system is to be fired. For example, an alumina green tape which is to be fired at high temperatures (1300-1600C) requires little if any inorganic binder since it is more likely to become sufficiently densified during firing. Thus, alumina green tape which is to be fired at high temperatures will contain 0-10% by volume inorganic binder. On the other hand, an alumina green tape which is to be fired at low temperatures (800-1000C) requires a substantial volumetric amount of inorganic binder which is sinterable at such lower firing temperatures. In the latter case, the fired tape is essentially a matrix of sintered glass binder in which alumina particles are dispersed. Therefore, alumina green tape which is to be fired at low temperature may contain more than 50% by volume inorganic binder, basis total inorganic solids. The chemical composition of the inorganic binder, if any, which may be used in either green tape, the thick film pastes for the conductive layers or the via fill paste is not critical with respect to obtaining the advantages of the invention.

In the manufacture of multilayers using the via fill compositions of the invention, the multilayer device may be fired in a non-reducing atmosphere such as air or nitrogen and it is unnecessary to use reducing atmospheres such as hydrogen. It is a distinct advantage of the compositions of the invention that they can be fired in air without special adjustment of the firing atmosphere.

### EXAMPLES

### Example 1

A thick film paste was prepared by conventional mixing of the components and roll milling. The paste had the following composition by weight:

| | |
|---|---|
| Organic Medium (Terpineol, Texanol®, Ethyl Cellulose | 4.25% |
| Butylated Hydroxy Toluene | 0.10% |
| Soya Lecithin | 1.00% |
| Texanol® | 0.65% |
| Ruthenium Metal Powder | 93.00% |

The above thick film paste was used as a via fill for an interconnected multilayer fabricated in the following manner:
1. A commercially available alumina-based green tape (Du Pont 851 Green Tape) was used to form the dielectric layers;
2. A gold thick film paste was used to form the outer conductor patterns of the multilayer.
3. A silver thick film paste was used to form the inner conductor patterns of the multilayer; and
4. The above-described ruthenium-containing paste was used to fill the via holes connecting the conductive patterns.

The assemblage consisting of four conductive and four dielectric layers was cut into separate sections and fired in air at 850C. To observe the effect of multiple firing, one section was fired 5 times and the other section was fired 10 times. Polished cross-sections of the vias in both sections were prepared and examined by Electron Probe Microanalysis (EPA) to determine the Ag and Au profiles through the sections. The two sections were also examined by Scanning Electron Microscopy (SEM) at 100-500X magnification.

The SEM photographs for both the 5X and 10X fired samples showed that the interfaces between the Au and the Ru and between the Ag and the Ru were well defined and that the Ru metal was well sintered. The EPA mapping showed that there was essentially no migration of either Au or Ag into the via fill upon firing.

### Example 2

To determine the effect of firing the via fill compositions of the invention in both air and nitrogen, layers of the above-described via fill paste were screen printed onto an alumina substrate and fired. The fired thickness of the printed layers was about 30 microns. One of the layers was fired in air at 850C and the other was fired in nitrogen at 900C. The air-fired layer showed a conductivity of 10 milliohms per square and the nitrogen-fired layer, which had a distinctive metal appearance, showed a conductivity of 35 millohms per square. These data show that good conductivity can be obtained in either firing atmosphere when firing over alumina. This is a clear advantage over the use of conventional via fill pastes in which reactivity of the alumina has a detrimental effect on the via fill properties.

## Claims

1. A thick film paste composition comprising by weight, basis total inorganic solids, 90-100% finely divided particles of a conductive metal which is not alloyable with silver selected from the group consisting of Os, Ru, Ir, Rh and mixtures and alloys thereof and 10-0% finely divided particles of inorganic binder, both dispersed in a liquid organic medium.

2. The composition of claim 1 in which the conductive metal is Ru.

3. The composition of claim 1 which contains 0.5-10% inorganic binder having a softening point of 400-1000C.

4. A method for forming electrically conductive vias between electrically functional layers separated by dielectric layers comprising the sequential steps:
(1) forming via holes in the dielectric layers separating the electrically functional layers;
(2) filling the via holes with the composition of claim 1 by screen printing; and
(3) firing the filled via holes to effect volatilization of the liquid organic medium from the paste and sintering of the conductive metal particles and of the inorganic binder if any.

5. The method of claim 4 in which the dielectric layers are formed from an alumina green tape which contains no inorganic binder, the via fill paste contains no inorganic binder and the firing is carried out at 1300-1600C in a non-reducing atmosphere.

6. The method of claim 4 in which the dielectric layers are formed from an alumina green tape which contains an inorganic binder, the via fill paste contains no inorganic binder and the firing is carried out at 800-1000C in a non-reducing atmosphere.

7. The method of claim 4 in which the electrically functional layers are selected from resistors and conductors.

8. The method of claim 4 in which the electrically functional layers are conductive layers prepared by printing and firing a thick film paste having the same composition as the via fill composition.

9. A fired multilayer electronic structure comprising alternating layers of dielectric tape and conductor patterns having interconnecting vias filled with the thick film paste of claim 1 from which the organic medium has been completely volatilized and the conductive metal sintered by firing the structure in a non-reducing atmosphere.

10. The fired multilayer electronic structure of claim 9 in which the fired dielectric tape layer is comprised of alumina and the structure is fired at a temperature of 1300-1600C.

11. The fired multilayer electronic structure of claim 9 in which the fired dielectric tape layer is comprised of 90-99.5% alumina and 10-0.5% inorganic binder having a softening point of 800-1000C and the structure is fired at a temperature of 1300-1600C.

12. The fired multilayer electronic structure of claim 9 in which the fired dielectric tape layer is comprised of a minor amount of alumina dispersed in a matrix of inorganic binder having a softening point of 400-700C and the structure is fired at a temperature of 800-1000C.

13. The fired multilayer electronic structure of claim 9 in which the fired compositions of the conductor patterns and of the via fill material are the same.

## Patentansprüche

1. Dickfilmpastenzusammensetzung, die, bezogen auf das Gewicht der gesamten anorganischen Feststoffe, 90-100% feiner Teilchen aus einem leitenden Metall, das mit Silber nicht legierbar ist und aus der Gruppe ausgewählt ist, die aus Os, Ru, Ir, Rh und Gemischen und Legierungen davon besteht, sowie 10-0% feiner Teilchen aus einem anorganischen Bindemittel umfaßt, die beide in einem flüssigen organischen Medium dispergiert sind.

2. Zusammensetzung gemäß Anspruch 1, wobei es sich bei dem leitenden Metall um Ru handelt.

3. Zusammensetzung gemäß Anspruch 1, die 0,5-10% anorganisches Bindemittel mit einem Erweichungspunkt von 400-1000°C enthält.

4. Verfahren zur Bildung elektrisch leitender Durchkontakte zwischen elektrisch-funktionellen Schichten, die durch dielektrische Schichten voneinander getrennt sind, umfassend die nacheinander durchzuführenden Schritte:
(1) Bilden von Kontaktlöchern in den dielektrischen Schichten, die die elektrisch-funktionellen Schichten voneinander trennen;
(2) Füllen der Kontaktlöcher mit der Zusammensetzung von Anspruch 1 durch Siebdruck; und
(3) Brennen der gefüllten Kontaktlöcher, so daß das flüssige organische Medium aus der Paste verflüchtigt wird und die leitenden Metallteilchen sowie das anorganische Bindemittel, falls vorhanden, gesintert werden.

5. Verfahren gemäß Anspruch 4, wobei die dielektrischen Schichten aus einem Aluminiumoxidgrünband gebildet sind, das kein anorganisches Bindemittel enthält, die Durchkontaktfüllpaste kein anorganisches Bindemittel enthält und das Brennen bei 1300-1600°C in einer nichtreduzierenden Atmosphäre durchgeführt wird.

6. Verfahren gemäß Anspruch 4, wobei die dielektrischen Schichten aus einem Aluminiumoxidgrünband gebildet sind, das ein anorganisches Bindemittel enthält, die Durchkontaktfüllpaste kein anorganisches Bindemittel enthält und das Brennen bei 800-1000°C in einer nichtreduzierenden Atmosphäre durchgeführt wird.

7. Verfahren gemäß Anspruch 4, wobei die elektrisch-funktionellen Schichten aus Widerständen und Leitern ausgewählt sind.

8. Verfahren gemäß Anspruch 4, wobei die elektrisch-funktionellen Schichten leitende Schichten sind, die durch Aufdrucken und Brennen einer Dickfilmpaste hergestellt werden, die dieselbe Zusammensetzung wie die Durchkontaktfüllzusammensetzung hat.

9. Gebrannte mehrschichtige elektronische Struktur, die abwechselnde Schichten aus dielektrischem Band und Leitermustern umfaßt und die Leiterschichten miteinander verbindende Durchkontakte aufweist, die mit der Dickfilmpaste von Anspruch 1 gefüllt sind, aus der durch Brennen der Struktur in einer nichtreduzierenden Atmosphäre das organische Medium vollständig verflüchtigt und das leitende Metall gesintert worden ist.

10. Gebrannte mehrschichtige elektronische Struktur gemäß Anspruch 9, wobei die gebrannte Schicht aus dielektrischem Band Aluminiumoxid umfaßt und die Struktur bei einer Temperatur von 1300-1600°C gebrannt wird.

11. Gebrannte mehrschichtige elektronische Struktur gemäß Anspruch 9, wobei die gebrannte Schicht aus dielektrischem Band 90-99,5% Aluminiumoxid und 10-0,5% anorganisches Bindemittel mit einer Erweichungstemperatur von 800-1000°C umfaßt und die Struktur bei einer Temperatur von 1300-1600°C gebrannt wird.

12. Gebrannte mehrschichtige elektronische Struktur gemäß Anspruch 9, wobei die gebrannte Schicht aus dielektrischem Band eine kleinere Menge Aluminiumoxid umfaßt, die in einer Matrix aus anorganischem Bindemittel mit einer Erweichungstemperatur von 400-700°C dispergiert ist, und die Struktur bei einer Temperatur von 800-1000°C gebrannt wird.

13. Gebrannte mehrschichtige elektronische Struktur gemäß Anspruch 9, wobei die gebrannten Zusammensetzungen der Leitermuster und des Durchkontaktfüllmaterials dieselben sind.

## Revendications

1. Une composition de pâte pour couche épaisse comprenant, en poids, sur la base de la teneur totale en matières solides minérales, de 90 à 100%. de particules finement divisées d'un métal conducteur qui ne peut pas s'allier à l'argent et choisi dans le groupe composé de Os, Ru, Ir, Rh, ainsi que leurs mélanges et alliages, et de 10 à 0% de particules finement divisées de liant minéral, tous deux dispersés dans un milieu organique liquide.

2. La composition selon la revendication 1, dans laquelle le métal conducteur est Ru.

3. La composition selon la revendication 1 qui contient de 0,5 à 10% d'un liant minéral ayant un point de ramollissement de 400-1000°C.

4. Un procédé de formation de traversées électriquement conductrices entre des couches électriquement fonctionnelles séparées par des couches diélectriques, comprenant les étapes suivantes :
(1) formation de trous traversants dans les couches diélectriques séparant les couches électriquement fonctionnelles ;
(2) remplissage des trous traversants avec la composition selon la revendication 1 par impression par sérigraphie; et
(3) cuisson des trous traversants remplis pour éliminer, par évaporation, le milieu organique liquide de la pâte et fritter les particules métalliques conductrices et le liant minéral, s'il existe.

5. Le procédé selon la revendication 4, dans lequel les couches diélectriques sont formées à partir d'un ruban brut d'alumine qui ne contient pas de liant minéral, la pâte de remplissage des trous traversants ne contient pas de liant minéral et la cuisson est réalisée à 1300-1600°C dans une atmosphère non réductrice.

6. Le procédé selon la revendication 4, dans lequel les couches diélectriques sont formées à partir d'un ruban brut d'alumine qui contient un liant minéral, la pâte de remplissage des trous traversants ne contient pas de liant minéral et la cuisson est réalisée à 800-1000°C dans une atmosphère non réductrice.

7. Le procédé selon la revendication 4, dans lequel les couches électriquement fonctionnelles sont choisies parmi des résistances et des conducteurs.

8. Le procédé selon la revendication 4, dans lequel les couches électriquement fonctionnelles sont des couches conductrices préparées en imprimant et en cuisant une pâte à couche épaisse de même composition que la composition de remplissage de traversées.

9. Une structure électronique multicouche cuite comprenant, en alternance, des couches de ruban diélectrique et de conducteurs imprimés dont les traversées sont remplis avec la pâte pour couche épaisse selon la revendication 1 de laquelle le milieu organique a été complètement éliminé par évaporation et dont le métal conducteur a été fritté en cuisant la structure dans une atmosphère non réductrice.

10. La structure électronique multicouche cuite, selon la revendication 9, dans laquelle la couche de ruban diélectrique cuite est constituée d'alumine et la structure est cuite à une température de 1300-1600°C.

11. La structure électronique multicouche cuite, selon la revendication 9, dans laquelle la couche de ruban diélectrique cuite est constituée de 90 à 99,5% d'alumine et de 10 à 0,5% d'un liant minéral ayant un point de ramollissement de 800-1000°C et la structure est cuite à une température de 1300-1600°C.

12. La structure électronique multicouche cuite, selon la revendication 9, dans laquelle la couche de ruban diélectrique cuite est constituée d'une quantité mineure d'alumine dispersée dans une matrice d'un liant minéral ayant un point de ramollissement de 400-700°C et la structure est cuite à une température de 800-1000°C.

13. La structure électronique multicouche cuite, selon la revendication 9, dans laquelle les compositions cuites des conducteurs imprimés et du matériau de remplissage des traversées sont les mêmes.
